Europäisches Patentamt

European Patent Office

Office européen des brevets

(11) Publication number: **0 091 079**

**B1**

(12) EUROPEAN PATENT SPECIFICATION

(45) Date of publication of patent specification: **10.06.87**

(51) Int. Cl.⁴: **H 01 L 29/78, H 01 L 29/08**

(21) Application number: **83103132.3**

(22) Date of filing: **29.03.83**

(54) **Power MOSFET.**

(30) Priority: **01.04.82 JP 54485/82**

(43) Date of publication of application:
**12.10.83 Bulletin 83/41**

(45) Publication of the grant of the patent:
**10.06.87 Bulletin 87/24**

(84) Designated Contracting States:
**DE FR GB**

(56) References cited:
**US-A-4 148 046**

**IEEE SPECTRUM, vol. 18, no. 1, January 1981,
pages 64-65, New York, USA, "Advances in
extending performance of power MOS field-
effect transistors promise to extend their
usefulness..."**

(73) Proprietor: **Kabushiki Kaisha Toshiba
72, Horikawa-cho Saiwai-ku
Kawasaki-shi Kanagawa-ken 210 (JP)**

(72) Inventor: **Tanabe, Hirohito
B-15-12, Shonan-Life-town 688-1, Endo
Fujisawa-shi Kanagawa-ken (JP)**
Inventor: **Ohata, Yu
1-11-7, Horinouchi
Suginami-ku Tokyo (JP)**
Inventor: **Miwa, Yukiharu
2-14-9, Shinkoyasu
Kanagawa-ku Yokohama-shi (JP)**
Inventor: **Kuramoto, Tsuyoshi
8-24-2, Konandai
Konan-ku Yokohama-shi (JP)**

(74) Representative: **Henkel, Feiler, Hänzel & Partner
Möhlstrasse 37
D-8000 München 80 (DE)**

The file contains technical information
submitted after the application was filed and
not included in this specification

Courier Press, Leamington Spa, England.

## Description

The present invention relates to a semiconductor device and, more particularly, to a power MOSFET.

A conventional power MOSFET has a plurality of independent source regions through a base region on a one-chip semiconductor substrate which serves as a common drain. The respective source regions are commonly connected to the source electrode through source electrode contacts. A gate electrode is formed on the base region through an insulating film. In this case, each source region takes up a very small area on the surface of the semiconductor chip. For this reason, it is very difficult to form source electrode contacts. As a result, the source region must be formed to have a considerably large size, thus degrading the packing density. A sufficient power output cannot be obtained by a semiconductor chip having a limited size, resulting in inconvenience.

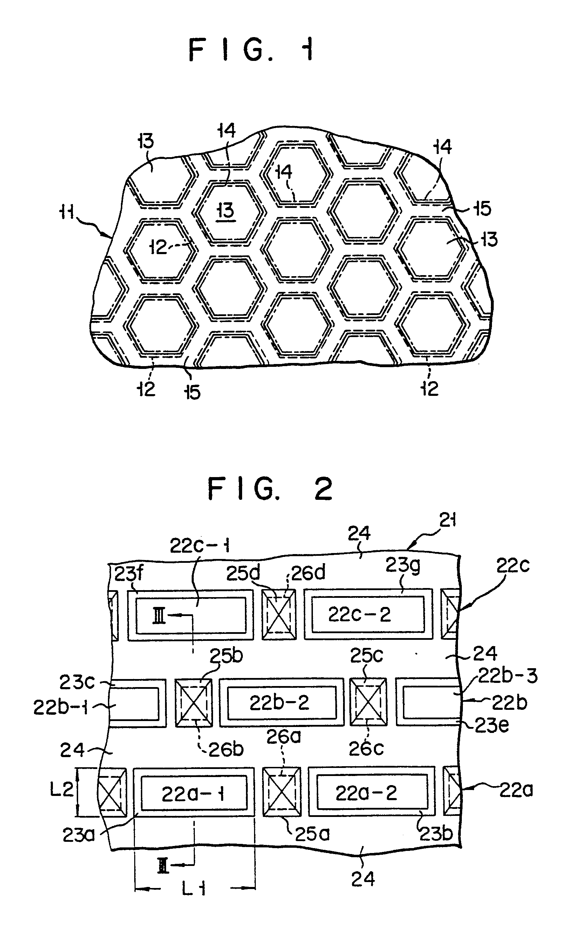

Fig. 1 is a plan view showing a conventional power MOSFET. Referring to Fig. 1, projections 12 arranged in a net-like pattern are formed integrally with an n-type semiconductor substrate 11, as indicated by the dashed lines. P-type regions 13 are formed in hexagonal recesses defined and surrounded by the projections 12, respectively. A hexagonal ring-shaped n-type source region 14 is formed at the boundary between each p-type region 13 and the corresponding projection 12 to have a predetermined width. Each source region 14 is formed between a portion (not shown) slightly toward the corresponding projection 12 from the solid line of the intermediate hexagon, and the alternate long and short dashed line of the smallest hexagon. Areas indicated by the solid lines correspond to gate electrodes 15 forming a net-like pattern, each of which covers the entire area of the corresponding projection 12 and part of the corresponding source region 14 through a gate insulating film.

In the power MOSFET having the structure described above, the source regions 14 respectively surrounded by the projections 12 are independent of each other. The source electrode contacts must be formed on the source regions 14, respectively. The formation of source electrode contacts on the respective source regions 14 may present a problem from the viewpoint of yield of the semiconductor devices. Furthermore, the source regions 14 may not be too much decreased in size in order to form source electrode contacts on the respective source regions 14. Then, the packing density of the prepared power MOSFET cannot be greatly increased. This indicates that a sufficient effective channel width cannot be obtained. As a result, a high power output cannot be obtained. The gate electrode 15 with the net-like pattern is usually formed with polycrystalline silicon which has a gate bonding pad area connected with an aluminum wire used as a taking-out electrode. As a result, wiring between the gate electrode 15 and the bonding pad area is made of polycrystalline silicon with relatively high resistivity, whereby the operating speed cannot be increased. Document IEEE SPECTRUM, vol. 18, no. 1, January 1981, pages 64, 65, New York, USA discloses a power MOS field-effect transistor according to the prior art part of claim 1 and having a vertical current flow in a TMOS FET structure. This power MOS field-effect transistor offers low resistance paths and permits a compact metallization on top and bottom surfaces to reduce the chip size.

It is an object of the present invention to provide a high-speed, high-power MOSFET which provides a high packing density and a sufficient effective channel width.

In order to achieve the above object of the present invention there is provided a power MOSFET comprising: a semiconductor substrate of one conductivity type which serves as a drain region, a plurality of projections of the said one conductivity type formed integrally on said semiconductor substrate, each of said plurality of projections having a rectangular surface and being projected upward from said semiconductor substrate, and said plurality of projections being arranged in a plurality of rows of projections and a plurality of columns of projections which are respectively spaced apart from each other by predetermined distances, a base region of another conductivity type formed to cover a surface portion of said semiconductor substrate which excludes said rectangular surfaces of said plurality of projections, said base region including channel regions of the said another conductivity type having a predetermined width and surrounding each of said projections, a source region of said one conductivity type formed in said base region near the outer side surface of each of said plurality of projections so as to sandwich said channel regions therebetween, an insulating film formed to cover the surfaces of said plurality of projections, said channel regions, and said source region, a gate film system formed on at least said surfaces of said plurality of projections and said channel regions on said insulating film, a plurality of source electrode contacts formed in conjunction with the source region, said plurality of source electrode contacts being formed such that each of said source electrode contacts is formed between two projections of said plurality of projections which are longitudinally adjacent to each other so as to connect said source regions respectively formed around said two projections, wherein said projections of one of said plurality of rows of projections are offset with respect to said projections of an adjacent one of said plurality of rows of projections by a distance corresponding to approximately one half of the distance between the centers of said projections in one of said rows of projections, said power MOSFET being characterized in that said gate film system consists of a plurality of gate films, a plurality of gate electrode contacts is connected to the gate films, and a metal gate electrode is commonly connected to said plurality of gate films through said gate electrode contacts, said source region is formed to completely surround the outer side surface of each plurality of projections the gate electrode contacts extend through said insulating film to be connected to said plurality of gate films, said source electrode contacts are formed such as to extend through said insulating film between two adjacent gate films.

This invention can be more fully understood from the following detailed description when taken in conjunction with the accompanying drawings, in which:

Fig. 1 is a plan view of a conventional power MOSFET;

Fig. 2 is a partial plan view of a power MOSFET according to an embodiment of the present invention; and

Fig. 3 is a perspective view showing part of the power MOSFET shown in Fig. 2 taken along the line III—III.

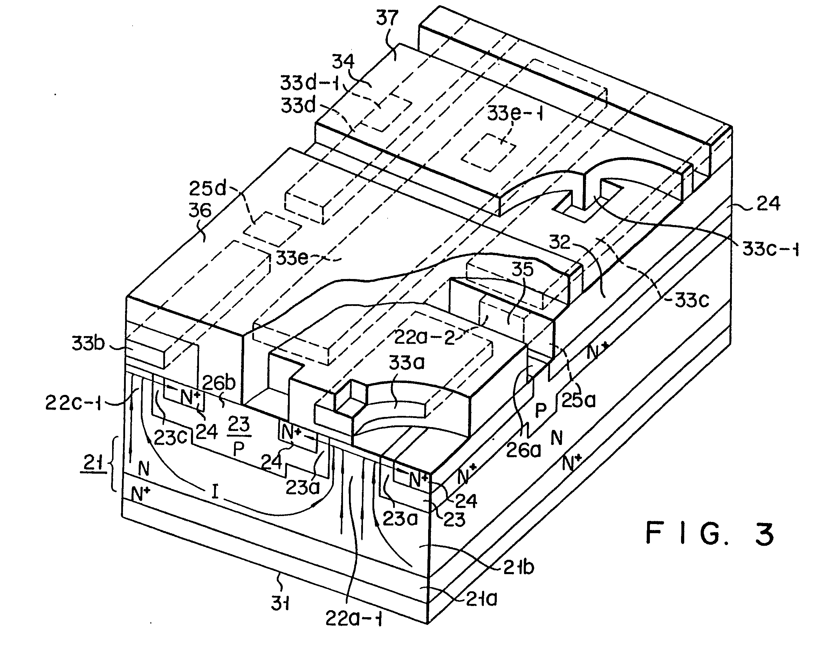

A power MOSFET according to an embodiment of the present invention will be described with reference to Figs. 2 and 3. Referring to Fig. 2, a plurality of projections 22a—1, 22a—2, ... , 22b—1, 22b—2, ... , and 22c—1, 22c—2, ... are formed on the surface of an n-type semiconductor substrate 21 so as to respectively have rectangular surfaces. The projections 22a—1, 22a—2, ... , 22c—2, ... are of an identical size. They are formed to be spaced apart from each other along their longitudinal direction by a predetermined distance. The projections 22a—1, 22a—2, ... are offset from the projections 22b—1, 22b—2, ... along their longitudinal direction such that the center of the long side of the rectangular surface of the projection 22b—2, for example, is aligned with the center of an area between the projections 22a—1 and 22a—2. The projections 22c—1, 22c—2, ... which are aligned on a row adjacent to the row of the projections 22b—1, 22b—2, ... are offset therefrom along their longitudinal direction such that the center of the long side of the rectangular surface of the projection 22c—1, for example, is aligned with the center of an area between the projections 22b—1 and 22b—2.

The surface portion of the semiconductor substrate 21 which excludes the rectangular surfaces of the projections 22a—1, 22a—2, ... , 22b—1, 22b—2, ... , and 22c—1, 22c—2 is covered with a p-type base region 23. Each projection (e.g., the projection 22a—1) is surrounded by a corresponding base region (e.g. a base region 23a) of a predetermined thickness. The surrounding base region is used as a channel region to be described later. The top surface of the base region 23a used as a channel region is at the same level as the surface of the projection 22a—1. Any other projection 22a—2, ... 22b—1, ... and 22c—1, ... has the same arrangement as the projection 22a—1.

An n+-type source region 24 is formed around the projection 22a—1 so as to sandwich the base region 23a as the channel region therebetween. The top surface of the source region 24 is at the same level as the top surfaces of the projection 22a—1 and the base region 23a.

The projection 22a—2 adjacent to the projection 22a—1 is surrounded by a base region 23b. A source region 24 is also formed around the base region 23b. A source electrode contact 25a is formed between the projections 22a—1 and 22a—2 so as to commonly connect the source regions 24. In practice, the top surfaces of base regions 23a, ... , 23g, ... which are formed around the projections 22a—1, ... , 22c—a, ... , and the top surfaces of the projections 22a—1, ... , 22c—1, ... are covered by a gate region through a gate insulating film. Gate electrodes and source electrodes are deposited through the insulating film, thereby completing a power MOSFET.

The internal structure and the arrangement of the gate and source electrodes of the power MOSFET of this embodiment will be described with reference to Fig. 3. Referring to Fig. 3, the n-type semiconductor substrate 21 comprises an n+-type substrate drain 21a and an n-type epitaxial drain 21b formed thereon. The lower surface of the substrate drain 21a is entirely covered by a drain electrode 31. The projections 22a—1, ... , 22b—1, ... , and 22c—1, ... are formed integrally with the epitaxial drain 21b. The surface of the epitaxial drain 21b is covered with the p-type base region 23. The projections 22a—1 and 22c—1 are surrounded by part of the base region 23 which is used as the channel regions 23a and 23c.

The source region 24 is formed around the projection 22a—1 through the channel region 23a.

In practice, in one case of manufacturing a power MOSFET, the n-type epitaxial drain 21b is uniformly formed on the surface of the substrate drain 21a to have a uniform thickness so as to correspond to the thickness of each of the projections 22a—1, ... , 22c—2, ... . Thereafter a photoresist pattern is formed on the projections 21a—1, ... and is used as a doping mask for doping the exposed portions with a p-type impurity, thereby forming the p-type base region 23. Furthermore, using a proper mask, source regions 24, ... may be formed on the surface layer of the base region 23. Therefore, the top surfaces of the projections 22a—1, ... are readily found to be at the same level as those of the channel regions 24, ... .

A silicon oxide film 32 is then formed to cover the entire surfaces of the projections 22a—1, ... , the base region 23, and the source regions 24, ... . A plurality of polycrystalline silicon gate films 33a, 33b, ... which respectively correspond to the projections 22a—1, ... are formed in the silicon oxide film 32. The polycrystalline silicon gate film 33a is formed to oppose the top surfaces of the projection 22a—1 and the channel region 23a so as to sandwich the oxide film 32 therebetween. Other polycrystalline silicon gate films 33b, ... are formed in a similar manner. Contact holes are formed in the oxide film 32 which is formed over the gate films 33c, 33e and 33d. Gate electrode contacts 33c—1, 33d—1 and 33e—1 are formed in the oxide film 32 through the respective contact holes. The gate electrode contacts 33c—1, 33d—1 and 33e—1 are commonly connected to a gate electrode 34 which is formed on the oxide film 32 so as to extend across the projections 22a—2, 22b—2 and 22c—2 (Fig. 2).

A source electrode contact hole 35 is formed in a portion between the projections 22a—1 and 22a—2. The contact hole 35 is formed by selectively etching the oxide film 32, such that one end of each of source regions 24 respectively formed around the projections 22a—1 and 22a—2 are exposed through the contact hole 35. At this time a portion 26a (Fig. 2) of the base region 23 is also exposed through the contact hole 35. A metal such as aluminum is deposited in the contact hole 35 so as to electrically connect the source regions 24, thereby forming a source electrode contact 25a. The portion 26a is connected to the contact 25a to short circuit the base region 23. Similarly, a source electrode contact 25d is formed between the projections 22c—1 and 22c—2. The source electrode contacts 25a, 25d formed so as to sandwich one of the projections (e.g., 22b—2 in Fig. 2) therebetween in a direction perpendicular to the long side of each projection, are commonly connected to a source electrode 36.

Two source electrodes are formed along two lines which are shifted by a distance corresponding to half of the long side of each projection 22a—1, ... , 22c—2, ... with respect to the line connecting the source electrode contacts 25a and 25d. The source electrode contact 25b is connected to one of the source electrodes (not shown), and the source electrode contact 25c is connected to the other of the source electrodes. Fig. 3 only illustrates a source electrode 37 which is connected to the power source electrode contact 25c.

With the above arrangement, a distance between the projections 22a—1 and 22a—2 can be determined so as to readily form the source electrode contact 25a. Furthermore, the size of the source electrode contact 25a does not adversely affect the effective channel width of the channel region 23a formed between the drain region of the projection 22a—1 and the source region 24. Therefore, the substrate area can be effectively utilized while the effective channel width can be sufficiently wide, thereby increasing the packing density of the power MOSFET. Since, the respective polycrystalline silicon gate electrodes are connected to the gate aluminum wiring electrode 34, the value of the gate resistance may be made very small compared with the conventional power MOSFET, thereby realizing a high operation speed.

For example, a power MOSFET having the structure of the embodiment shown in Figs. 2 and 3 was formed on a chip having dimensions of 5.5 mm × 5.5 mm. In this case, the length L1 and width L2 of the respective projections 22a—1, ... , 22c—2, ... are 200 μm, and 27 μm, respectively. An effective channel width of the power MOSFET was 114 cm, and a gate resistance thereof was 0.3 ohm. On the other hand, a conventional power MOSFET was formed on a chip having the same dimensions as those described above. An effective channel width of the conventional power MOSFET was 93 cm, and a gate resistance thereof was 1.7 ohms. As a result, it is found that the power MOSFET according to the present invention has a wide effective channel width, a small gate resistance and a high power with a high operation speed.

Furthermore, as can be seen in Fig. 2, since the four source regions 24 formed around the projections 22a—1, 22b—1, 22b—2 and 22c—1 are commonly connected through the single source electrode contact 25b, for example, the yield of the power MOSFETs is greatly increased, thus contributing to an increase in the packing density of the device.

In operation, when predetermined voltages are applied to the drain electrode 31, the source electrodes 36 and 37, and the gate electrode 34, a current I flows from the epitaxial drain 21b to all the projections 22a—1, ... , 22c—1, ... as shown in Fig. 3. The current I further flows in the source regions 24 from the side surfaces of all the projections through the channel regions 23a, 23b, ... . This operation is similar to the conventional power MOSFET, and a detailed description thereof will be omitted.

In the above embodiment, the semiconductor substrate drain 21 is of n-type, and the source region is of n$^+$-type. However, the substrate may comprise a p-type semiconductor substrate, and the source region may comprise a p$^+$-type source region.

**Claims**

1. A power MOSFET, comprising:
a semiconductor substrate (21) of one conductivity type which serves as a drain region,
a plurality of projections (22a—1, 22a—2, ... 22c—1, 22c—2) of the said one conductivity type formed integrally on said semiconductor substrate (21), each of said plurality of projections having a rectangular surface and being projected upward from said semiconductor substrate, and said plurality of projections being arranged in a plurality of rows of projections and a plurality of columns of projections which are respectively spaced apart from each other by predetermined distances,
a base region (23) of another conductivity type formed to cover a surface portion of said semiconductor substrate (21) which excludes said rectangular surfaces of said plurality of projections, said base region (23) including channel regions of the said another conductivity type having a predetermined width and surrounding each of said projections,
a source region (24) of said one conductivity type formed in said base region (23) near the outer side surface of each of said plurality of projections so as to sandwich said channel regions therebetween,
an insulating film (32) formed to cover the surfaces of said plurality of projections, said channel regions, and said source region,

a gate film system (33a—33e) formed on at least said surfaces of said plurality of projections and said channel regions on said insulating film (32),

a plurality of source electrode contacts (25a, 25b, 25c) formed in conjunction with the source region,

said plurality of said electrode contacts (25a, 25b, 25c) being formed such that each of said source electrode contacts is formed between two projections of said plurality of projections which are longitudinally adjacent to each other so as to connect said source regions respectively formed around said two projections,

wherein said projections of one of said plurality of rows of projections are offset with respect to said projections of an adjacent one of said plurality of rows of projections by a distance corresponding to approximately one half of the distance between the centers of said projections in one of said rows of projections,

characterized in that

said gate film system consists of a plurality of gate films,

a plurality of gate electrode contacts (33c—1, 33d—1, 33e—1) is connected to the gate films (33a—33e), and a metal gate electrode is commonly connected to said plurality of gate films through said gate electrode contacts,

said source region (24) is formed to completely surround the outer side surface of each of said plurality of projections (22a—1, 22a—2, 22b—1, 22b—2, 22c—1, 22c—2),

the gate electrode contacts (33c—1, 33d—1, 33e—1) extend through said insulating film (32) to be connected to said plurality of gate films (33a—33e),

said source electrode contacts are formed such as to extend through said insulating film between two adjacent gate films.

2. A power MOSFET according to claim 1, characterized in that said semiconductor substrate (21) comprises an $n^+$-type substrate drain (21a) and an n-type epitaxial drain (21b) formed on said $n^+$-type substrate drain (21a), said plurality of projections (21a—1, 22a—2, 22c—1, 22c—2) being formed in a surface layer of said n-type epitaxial drain (21b).

3. A power MOSFET according to claim 1, characterized in that said gate films (33a—33e) comprise polycrystalline silicon films.

4. A power MOSFET according to claim 1, characterized in that said semiconductor substrate comprises a $p^+$-type substrate drain and a p-type epitaxial drain formed on said $p^+$-type substrate drain, said plurality of projections being formed in a surface of said p-type epitaxial drain.

**Patentansprüche**

1. Leistungs-MOSFET, umfassend

ein als Drainzone dienendes Halbleitersubstrat (21) des einen Leitfähigkeitstyps,

eine Vielzahl von materialeinheitlich auf dem Halbleitersubstrat (21) ausgebildeten Erhebungen (22a—1, 22a—2, ... 22c—1, 22c—2) des einen Leitfähigkeitstyps, die jeweils eine rechteckige (Ober-)Fläche aufweisen und vom Halbleitersubstrat nach oben ragen und die jeweils in einer Anzahl von Reihen von Erhebungen und einer Anzahl von Spalten von Erhebungen mit jeweils einem vorbestimmten Abstand voneinander angeordnet sind,

eine einen anderen Leitfähigkeitstyp aufweisende Basiszone (23), die einen Oberflächenabschnitt des Halbleitersubstrats (21) unter Aussparung der rechteckigen Flächen der Vielzahl von Erhebungen bedeckend ausgebildet ist und die eine vorbestimmte Breite besitzende und jede der Erhebungen umschließende Kanalzonen des anderen Leitfähigkeitstyps aufweist,

eine in der Basiszone (23) nahe der Außenseitenfläche jeder der Vielzahl von Erhebungen so ausgebildete, daß die Kanalzone dazwischen eingeschlosen sind, Sourcezone (24) des einen Leitfähigkeitstyps,

einen die (Ober-)Flächen der Erhebungen, der Kanalzonen und der Sourcezone bedeckend ausgebildete Isolierschicht (32),

ein auf zumindest den Flächen der Vielzahl von Erhebungen und der Kanalzonen auf der Isolierschicht (32) ausgebildetes Gateschichtsystem (33a—33e), (und)

eine Anzahl von in Verbindung mit der Sourcezone ausgebildeten Sourceelektrodenkontakten (25a, 25b, 25c),

wobei die Anzahl von Sourceelektrodenkontakten (25a, 25b, 25c) so ausgebildet sind, daß jeder der Sourceelektrodenkontakte zwischen zwei Erhebungen der Vielzahl von Erhebungen, die in Längsrichtung nebeneinander liegen, geformt ist, um damit die jeweils um die beiden Erhebungen ausgebildeten Sourcezonen zu verbinden, (und)

wobei die Erhebungen einer die zahlreichen Reihen von Erhebungen in bezug auf die Erhebungen einer benachbarten Reihe der zahlreichen Reihen von Erhebungen um einen Abstand entsprechend etwa der Hälfte des Abstands zwischen den Zentren der Erhebungen in der einen Reihe von Erhebungen versetzt sind,

dadurch gekennzeichnet, daß

das Gateschichtsystem aus einer Anzahl von Gateschichten (oder-filmen) besteht,

eine Anzahl von Gateelektrodenkontakten (33c—1, 33d—1, 33e—1) mit den Gateschichten (33a—33c) verbunden sind und eine Metall-Gateelektrode über die Gateelektrodenkontakte mit der Anzahl von Gateschichten zusammengeschaltet ist,

die Sourcezone (24) so ausgebildet ist, daß sie die Außenseitenfläche jeder der zahlreichen Erhebungen (22a—1, 22a—2, 22b—1, 22b—2, 22c—1, 22c—2) vollständig umschließt,

die Gateelektrodenkontakte (33c—1, 33d—1, 33e—1) sich durch die Isolierschicht (32) erstrecken und mit der Anzahl von Gateschichten (33a—33e) verbunden sind, (und)

die Sourcelektrodenkontakte so ausgebildet sind, daß sie sich zwischen zwei benachbarten Gateschichten durch die Isolierschicht erstrecken.

2. Leistungs-MOSFET nach Anspruch 1, dadurch gekennzeichnet, daß das Halbleitersubstrat (21) einen n⁺-Typ-Substrat-Drain (21a) und einen auf dem n⁺-Typ-Substrat-Drain (21a) ausgebildeten epitaxialen n-Typ-Drain (21b) aufweist und die Vielzahl von Erhebungen (22a—1, 22a—2, ... 22c—1, 22c—2) in einer Oberflächenschicht des epitaxialen n-Typ-Drains (21b) ausgebildet sind.

3. Leistungs-MOSFET nach Anspruch 1 dadurch gekennzeichnet, daß die Gateschichten (33a—33e) polykristalline Siliziumschichten sind.

4. Leistungs-MOSFET nach Anspruch 1, dadurch gekennzeichnet, daß das Halbleitersubstrat einen p⁺-Typ-Substrat-Drain und einen auf dem p⁺-Typ-Substrat-Drain ausgebildeten epitaxialen p-Typ-Drain aufweist und die Vielzahl von Erhebungen in einer Oberfläche des epitaxialen p-Typ-Drains ausgebildet sind.

**Revendications**

1. MOSFET de puissance, comprenant:
un substrat semiconducteur (21) d'un premier type de conductivité qui sert de région de drain,
plusieurs parties saillantes (22a—1, 22a—2, ... , 22c—1, 22c—2) dudit premier type de conductivité formées solidairement sur ledit substrat semiconducteur (21), chacune desdites parties saillantes possédant une surface rectangulaire et faisant saille vers le haut depuis ledit substrat semiconducteur, et les parties saillantes étant disposées suivant plusieurs rangées de parties saillantes et plusieurs colonnes de parties saillantes qui sont respectivement écartées les unes des autres de distances prédéterminées,
une région de base (23) de l'autre type de conductivité, formée de manière à couvrir une partie de surface dudit substrat semiconducteur (21) qui exclut lesdites surfaces rectangulaires desdites parties saillantes, ladite région de base (23) comportant des régions de canal dudit autre type de conductivité présentant une largeur prédéterminée et entourant chacune desdites parties saillantes,
une région de source (24) dudit premier type de conductivité formée dans ladite région de base (23) au voisinage de la surface latérale extérieure de chacune desdites parties saillantes afin de pendre en sandwich lesdites régions de canal entre elles,
une pellicule isolante (32) formée de manière à couvrir les surfaces desdites parties saillantes, desdites régions de canal, et de ladite région de source,
un système de pellicules de grille (33a—33e) formé sur au moins lesdites surfaces desdites parties saillantes et desdites régions de canal sur ladite pellicule isolante (32),
plusieurs contacts d'électrode de source (25a, 25b, 25c) formés en relation avec la région de source,
les différents contacts d'électrode de source (25a, 25b, 25c) étant formés de façon que chacun desdits contacts d'électrode de source soit formé entre deux parties saillantes qui sont longitudinalement adjacentes l'une à l'autre de manière à connecter lesdites régions de source respectivement formées autour desdites deux parties saillantes,
ou lesdites parties saillantes de l'une desdites rangées de parties saillantes sont décalées par rapport auxdites parties saillantes d'une rangée adjacente de parties saillantes d'une distance qui correspond à environ la moitié de la distance séparant les centres desdites parties saillantes dans l'une desdites rangées de parties saillantes,
caractérisé en ce que:
ledit système de pellicules de grille est constitué de plusieurs pellicules de grille,
plusieurs contacts d'électrode de grille (33c—1, 33d—1, 33e—1) sont connectés aux pellicules de grille (33a—33e), et une électrode de grille de métal est connectée en commun auxdites pellicules de grille par l'intermédiaire desdits contacts d'électrode de grille,
ladite région de source (24) est formée de manière à entourer complètement la surface latérale extérieure de chacune desdites parties saillantes (22a—1, 22a—2, 22b—1, 22b—2, 22c—1, 22c—2),
les contacts d'électrode de grille (33c—1, 33d—1, 33e—1) s'étendent au travers de ladite pellicule isolante (32) afin d'être connectés auxdites pellicules de grille (33a—33e),
lesdits contacts d'électrode de source sont formés de manière à s'étendre au travers de ladite pellicule isolante entre deux pellicules de grille adjacentes.

2. MOSFET de puissance selon la revendication 1, caractérisé en ce que ledit substrat senicconducteur (21) comprend un drain de substrat (21a) de type n⁺ et un drain épitaxial (21b) de type n formé sur drain de substrat (21a) de type n⁺, lesdites parties saillantes (22a—1, 22a—2, ... , 22c—1, 22c—2) étant formées dans une couche de surface dudit drain épitaxial (21b) de type n.

3. MOSFET de puissance selon la revendication 1, caractérisé en ce que lesdites pellicules de grille (33a—33e) comprennent des pellicules en silicium polycristallin.

4. MOSFET de puissance selon la revendication 1, caractérisé en ce que ledit substrat semiconducteur comprend un drain de substrat de type p⁺ et un drain épitaxial de type p formé sur ledit drain de substrat de type p⁺, lesdites parties saillantes étant formées dans une surface dudit drain épitaxial de type p.

# FIG. 1

# FIG. 2

FIG. 3